# EUROPEAN PATENT SPECIFICATION

(11) **EP 4 175 441 B1**
(45) Date of publication and mention of the grant of the patent: **02.12.2026**
(21) Application number: 22203150.2
(22) Date of filing: 21.10.2022
(51) Int. Cl.: H10K 59/122, H10K 59/124, H10K 59/80, H10K 71/16

(54) **DISPLAY DEVICE**
ANZEIGEVORRICHTUNG
DISPOSITIF D'AFFICHAGE

(30) Priority: 28.10.2021 KR 20210145797
(43) Date of publication of application: 03.05.2023
(73) Proprietor: Samsung Display Co., Ltd., Yongin-si, Gyeonggi-do 17113 (KR)
(72) Inventor: LEE, Jaehun, Seongnam-si (KR); KIM, Hye Sun, Goyang-si (KR); SIM, Junho, Hwaseong-si (KR); LEE, Sanghyun, Hwaseong-si (KR); JUNG, Yang-Ho, Seoul (KR); HONG, Pil Soon, Seoul (KR)
(74) Representative: Marks & Clerk LLP

(56) References cited:
- US-A1- 2017 373 124
- US-A1- 2018 197 929
- US-A1- 2021 249 492

## Description

### BACKGROUND

### 1. Field

Embodiments relate generally to a display device. More particularly, embodiments relate to a display device that provides visual information.

### 2. Description of the Related Art

A flat panel display device is being used as a display device that replaces a cathode ray tube display due to characteristics such as light weight and thinness. Such a flat panel display device may include a liquid crystal display device and an organic light emitting display device, for example.

The organic light emitting display device may include a pixel defining layer defining a pixel and a spacer disposed on the pixel defining layer. In a case where the pixel defining layer and the spacer include different materials from each other, productivity may be improved by adding the number of masks and process steps.

In United States Patent Application US2018/197929A1, there is described an organic light emitting diode display device that includes a substrate, a protection layer on the substrate, the protection layer including a trench pattern and a recessed portion, a first electrode on the protection layer, a pixel defining layer on the protection layer, the pixel defining layer defining an opening that exposes at least a part of the first electrode, an organic light emitting layer on the first electrode, and a second electrode on the organic light emitting layer. The recessed portion overlaps the opening and is spaced apart from an edge of the opening in a plan view. The trench pattern includes a plurality of trenches extending along a first direction. Each trench of the plurality of trenches is spaced apart from the first electrode in a plan view and has a concave cross-section.

In United States Patent Application US2021/249492A1, there is described a display device that includes two pixel circuits spaced apart from each other with a transmission area therebetween, a first insulating layer on the two pixel circuits, two pixel electrodes on the first insulating layer, and a second insulating layer including a first portion covering an edge of each of the two pixel electrodes and a second portion, wherein the first insulating layer includes a third portion overlapping the two pixel electrodes, and a fourth portion having a height greater than a height from the substrate to a top surface of the third portion, wherein the first portion of the second insulating layer overlaps the third portion, and the second portion of the second insulating layer overlaps the fourth portion, wherein a height from the substrate to a top surface of the second portion is greater than a height from the substrate to a top surface of the first portion.

In United States Patent Application US2017/373124A1, there is described an electroluminescence display device including a first electrode, a second electrode facing the first electrode, an emission layer between the first electrode and the second electrode, and a bank layer defining the emission layer. The bank layer may be disposed between the first electrode and the second electrode. The bank layer may include a first bank layer and a second bank layer. The second bank layer may include a black pigment. The first bank layer may be closer to the first electrode than the second bank layer, and the first bank layer may have a lower permittivity than the second bank layer.

### SUMMARY

Embodiments provide a display device with improved display quality.

The present invention is defined in independent claim 1. Particular aspects of the invention are defined in the dependent claims.

In an embodiment, each of the bank portion and the spacer portion may include a black pigment.

In an embodiment, each of the bank portion and the spacer portion may include a negative photosensitive material.

In an embodiment, a first thickness of the second protrusion portion, which is a distance from an upper surface of the first protrusion portion to an upper surface of the second protrusion portion, may be smaller than a second thickness of the second flat portion, which is a distance from the upper surface of the first flat portion to the upper surface of the second flat portion, in a cross-sectional view.

In an embodiment, an upper surface of the spacer portion and an upper surface of the second protrusion portion may be located at different levels from each other in a cross-sectional view.

In an embodiment, the upper surface of the spacer portion may be located at a higher level than the upper surface of the second protrusion portion in the cross-sectional view.

In an embodiment, the planarization layer may include an organic insulating material.

In an embodiment, the driving element may include an active layer disposed on the substrate, a gate electrode disposed on the active layer, and a source electrode and a drain electrode, which are disposed on the gate electrode and connected to the active layer.

In an embodiment, the display device may further include a light emitting layer disposed on the pixel electrode and a common electrode disposed on the pixel defining layer and the light emitting layer.

In an embodiment, the display device may further include an encapsulation structure disposed on the common electrode, where the encapsulation structure may include an organic layer and an inorganic layer, a light blocking layer disposed on the encapsulation structure and overlapping the pixel defining layer and a reflection control layer disposed on the encapsulation structure and covering the light blocking layer.

The present invention is defined in the claims.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to an embodiment.
FIG. 2 is a cross-sectional view taken along line I-I' of FIG. 1.
FIG. 3 is a cross-sectional view illustrating an enlarged area 'A' of FIG. 2.
FIGS. 4, 5, 6, 7, 8, 9, and 10 are cross-sectional views illustrating an embodiment of a method of manufacturing the display device of FIG. 3.
FIG. 11 is a block diagram illustrating an embodiment of an electronic device including the display device of FIG. 1.
FIG. 12 is a diagram illustrating an embodiment in which the electronic device of FIG. 11 is implemented as a television.
FIG. 13 is a diagram illustrating an embodiment in which the electronic device of FIG. 11 is implemented as a smartphone.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the disclosure will be described in detail with reference to the accompanying drawings.

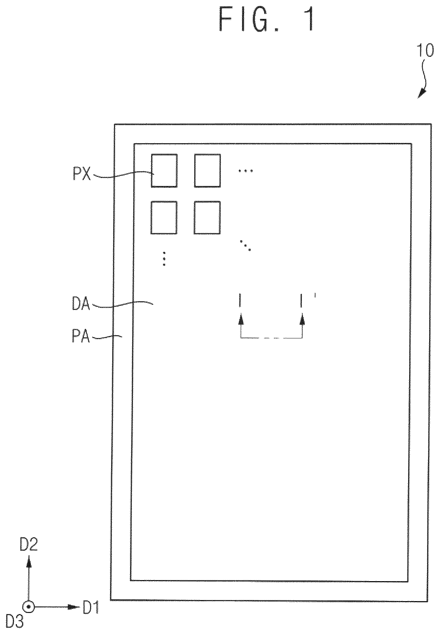

FIG. 1 is a plan view illustrating a display device according to an embodiment.

Referring to FIG. 1, an embodiment of the display device 10 includes a display area DA and a peripheral area PA. The display area DA may be defined as an area in which an image is displayed by generating light or adjusting transmittance of light provided from a light source. The peripheral area PA may be defined as an area that does not display an image. In an embodiment, the peripheral area PA may surround at least a portion of the display area DA. In an embodiment, for example, the peripheral area PA may entirely surround the display area DA.

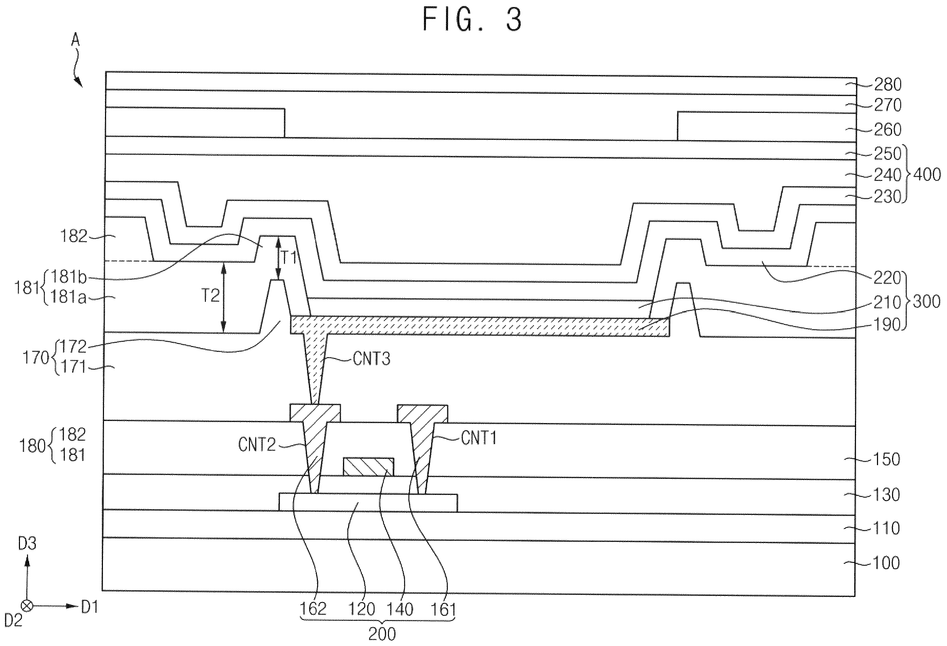

A plurality of pixels PX may be disposed in the display area DA. In an embodiment, for example, each of the plurality of pixels PX may include a driving element (e.g., a driving element 200 of FIG. 3), a light emitting element (e.g., a light emitting element 300 of FIG. 3), and the like.

One pixel PX may display one predetermined basic color. In an embodiment, one pixel PX may be a minimum unit capable of displaying colors independent of other pixels PX. In an embodiment, for example, one pixel PX may display any one of red, green, and blue colors.

The plurality of pixels PX may be arranged in a matrix shape along a first direction D1 and a second direction D2 intersecting the first direction D1. In an embodiment, for example, the first direction D1 and the second direction D2 may be orthogonal to each other.

In an embodiment, the display device 10 may be an organic light emitting display device ("OLED"), but the configuration of the invention is not limited thereto. In an alternative embodiment, the display device 10 may include a liquid crystal display device ("LCD"), a field emission display device ("FED"), a plasma display device ("PDP"), or an electrophoretic display device ("EPD"). Hereinafter, for convenience of description, embodiments in which the display device 10 is an organic light emitting display device will be described in detail.

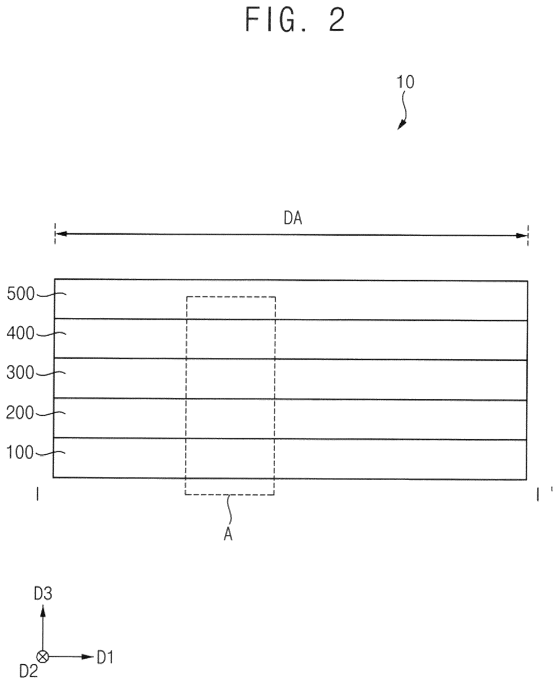

FIG. 2 is a cross-sectional view taken along line I-I' of FIG. 1. FIG. 3 is a cross-sectional view illustrating an enlarged area 'A' of FIG. 2.

Referring to FIGS. 1, 2 and 3, The display device 10 includes a substrate 100, a driving element 200, a planarization layer 170 and a pixel defining layer 180. The display device may also include a buffer layer 110, a gate insulating layer 130, an interlayer insulating layer 150, a light emitting element 300, an encapsulation structure 400, a light blocking layer 260, a reflection control layer 270, an overcoat layer 280 and a window member 500.

In an embodiment, the driving element 200 may include an active layer 120, a gate electrode 140, a source electrode 161, and a drain electrode 162. The light emitting element 300 may include a pixel electrode 190 and a light emitting layer 210, and a common electrode 220. In an embodiment, the encapsulation structure 400 may include a first inorganic encapsulation layer 230, an organic encapsulation layer 240, and a second inorganic encapsulation layer 250.

The display device 10 includes the display area DA and the peripheral area PA. In such an embodiment where the display device 10 includes the display area DA and the peripheral area PA, the substrate 100 also includes the display area DA and the peripheral area PA.

The substrate 100 may include a transparent material or an opaque material. In an embodiment, for example, the substrate 100 may be formed of or defined by a transparent resin substrate. In such an embodiment, the transparent resin substrate may include a polyimide substrate, for example. In such an embodiment, the polyimide substrate may include a first polyimide layer, a barrier film layer, a second polyimide layer, and the like. In an alternative embodiment, the substrate 100 may include or be defined by a quartz substrate, a synthetic quartz substrate, a calcium fluoride substrate, a fluorine-doped quartz substrate, a soda-lime glass substrate, a non-alkali glass substrate, or the like. These may be used alone or in combination with each other.

The buffer layer 110 may be disposed on the substrate 100. The buffer layer 110 may prevent diffusion of metal atoms or impurities from the substrate 100 to the driving element 200. In an embodiment, where a surface of the substrate 100 is not uniform, the buffer layer 110 may serve to improve a flatness of the surface of the substrate 100. In an embodiment, for example, the buffer layer 110 may include silicon oxide, silicon nitride, or the like. These may be used alone or in combination with each other.

The active layer 120 may be disposed in the display area DA on the buffer layer 110. The active layer 120 may include a metal oxide semiconductor, an inorganic semiconductor (e.g., amorphous silicon, polysilicon), or an organic semiconductor. The active layer 120 may include a source region, a drain region, and a channel region positioned between the source region and the drain region.

The gate insulating layer 130 may be disposed on the buffer layer 110. The gate insulating layer 130 may cover the active layer 120. The gate insulating layer 130 may sufficiently cover the active layer 120 on the buffer layer 110 and may have a substantially flat upper surface without creating a step difference around the active layer 120. In an alternative embodiment, the gate insulating layer 130 may cover the active layer 120 on the buffer layer 110 and may be disposed along a profile of the active layer 120 with a uniform thickness. In an embodiment, for example, the gate insulating layer 130 may include an inorganic insulating material. In such an embodiment, the inorganic insulating material included in the gate insulating layer 130 may include silicon oxide (SiOₓ), silicon nitride (SiNₓ), silicon carbide (SiCₓ), silicon oxynitride (SiOₓN_{y}), silicon oxycarbide (SiOₓC_{y}), or the like, for example. These may be used alone or in combination with each other.

The gate electrode 140 may be disposed in the display area DA on the gate insulating layer 130. The gate electrode 140 may overlap the channel region of the active layer 120. In an embodiment, for example, the gate electrode 140 may include a metal, an alloy, a metal nitride, a conductive metal oxide, a transparent conductive material, or the like. These may be used alone or in combination with each other.

The interlayer insulating layer 150 may be disposed on the gate insulating layer 130. The interlayer insulating layer 150 may cover the gate electrode 140. The interlayer insulating layer 150 may sufficiently cover the gate electrode 140 on the gate insulating layer 130 and may have a substantially flat upper surface without generating a step difference around the gate electrode 140. In an alternative embodiment, the interlayer insulating layer 150 may cover the gate electrode 140 on the gate insulating layer 130 and may be disposed along a profile of the gate electrode 140 with a uniform thickness. In an embodiment, the interlayer insulating layer 150 may include an inorganic insulating material. In such an embodiment, the inorganic insulating material included in the interlayer insulating layer 150 may include silicon oxide, silicon nitride, silicon carbide, or the like, for example. These may be used alone or in combination with each other.

The source electrode 161 and the drain electrode 162 may be disposed in the display area DA on the interlayer insulating layer 150. The source electrode 161 may be connected to the source region of the active layer 120 through a first contact hole CNT1 defined through (e.g., formed by removing) a first portion of the gate insulating layer 130 and the interlayer insulating layer 150. The drain electrode 162 may be connected to the drain region of the active layer 120 through a second contact hole CNT2 defined through (e.g., formed by removing) a second portion of the gate insulating layer 130 and the interlayer insulating layer 150. In an embodiment, for example, each of the source electrode 161 and the drain electrode 162 may include a metal, an alloy, a metal nitride, a conductive metal oxide, a transparent conductive material, or the like. These may be used alone or in combination with each other.

Accordingly, the driving element 200 including the active layer 120, the gate electrode 140, the source electrode 161, and the drain electrode 162 may be disposed in the display area DA on the substrate 100.

The planarization layer 170 may be disposed on the interlayer insulating layer 150. The planarization layer 170 may sufficiently cover the source electrode 161 and the drain electrode 162. In an embodiment, for example, the planarization layer 170 may have a substantially flat upper surface, and a planarization process may be added to the planarization layer 170 to implement such the flat upper surface of the planarization layer 170.

The planarization layer 170 may include an inorganic insulating material or an organic insulating material. In an embodiment, the planarization layer 170 may include an organic insulating material. In such an embodiment, the organic insulating material included the planarization layer 170 may include photoresists, polyacrylic resins, polyimide resins, siloxane resins, acrylic resins, or epoxy resins, for example. These may be used alone or in combination with each other.

In an embodiment, the planarization layer 170 may have a multilayer structure including a first planarization layer including a substantially transparent siloxane-based resin and a second planarization layer including a substantially transparent photosensitive polyimide ("PSPI") disposed on the first planarization layer. In such an embodiment, the first planarization layer and the second planarization layer may include different materials from each other.

The planarization layer 170 includes a first flat portion 171 covering the driving element 200 on the driving element 200 and a first protrusion portion 172 protruding in a thickness direction (e.g., a third direction D3) from an upper surface of the first flat portion 171 adjacent to the pixel electrode 190. In such an embodiment, the first flat portion 171 and the first protrusion portion 172 may be integrally formed as a single unitary indivisible part.

The pixel electrode 190 may be disposed in the display area DA and is disposed on the planarization layer 170. In an embodiment, the pixel electrode 190 is disposed on the first flat portion 171 of the planarization layer 170 to be adjacent to the first protrusion portion 172 of the planarization layer 170. The pixel electrode 190 may be connected to the drain electrode 162 through a third contact hole CNT3 defined through (e.g., formed by removing) a portion of the planarization layer 170. In an embodiment, for example, the pixel electrode 190 may include a metal, an alloy, a metal nitride, a conductive metal oxide, a transparent conductive material, or the like. These may be used alone or in combination with each other.

The pixel defining layer 180 is disposed on the planarization layer 170 and may be disposed on the pixel electrode 190. The pixel defining layer 180 includes a bank portion 181 disposed on the planarization layer 170 and in which an opening is defined to expose a portion of the pixel electrode 190, and a spacer portion 182 protruding in the thickness direction (e.g., a third direction D3) from an upper surface of the bank portion 181. During a manufacturing process of the display device 10, the spacer portion 182 may serve to support a mask layer from collapsing when the light emitting layer 210 is formed.

In an embodiment, for example, the spacer portion 182 may have one of a truncated pyramid, a prism, a truncated cone, and a cylindrical shape in a cross-section.

The spacer portion 182 does not overlap the first protrusion portion 172 of the planarization layer 170 in the third direction D3. Therefore, the spacer portion 182 is spaced apart from the first protrusion portion 172 of the planarization layer 170 in a plan view. Herein, "in a plan view" does mean when viewed from a plan view in the third direction D3

The bank portion 181 and the spacer portion 182 may be integrally formed as a single unitary indivisible part through a photolithography process using a photosensitive material as a material. In such an embodiment, the bank portion 181 and the spacer portion 182 may include a same material as each other. In an embodiment, each of the bank portion 181 and the spacer portion 182 may include a negative photosensitive material.

Each of the bank portion 181 and the spacer portion 182 may include an inorganic insulating material or an organic insulating material. In an embodiment, each of the bank portion 181 and the spacer portion 182 may include an organic insulating material. In such an embodiment, the organic insulating material included in each of the bank portion 181 and the spacer portion 182 may include polyacrylic resin, polyimide-based resin, acrylic resin, phenol resin, or the like, for example. These may be used alone or in combination with each other.

In an embodiment, each of the bank portion 181 and the spacer portion 182 may further include a black pigment or a black dye having a high light absorption rate. In an embodiment, for example, carbon black or the like may be used as the black pigment or the black dye. However, the invention is not limited thereto.

The bank portion 181 includes a second flat portion 181a disposed on the planarization layer 170 and a second protrusion portion 181b protruding in the thickness direction (i.e. the third direction D3) from an upper surface of the second flat portion 181a overlapping the first protrusion portion 172. In an embodiment, for example, a thickness from the upper surface of the second flat portion 181a to the upper surface of the second protrusion portion 181b may be about 0.2 micrometer (µm) or more.

The upper surface of the spacer portion 182 and the upper surface of the second protrusion portion 181b may be located at different levels from each other. In an embodiment, the upper surface of the spacer portion 182 may be located at a higher level than the upper surface of the second protrusion portion 181b. Alternatively, the upper surface of the spacer portion 182 may be located at a same level as the upper surface of the second protrusion portion 181b. Here, a level of a surface may be defined based on a distance thereof from an upper surface of the substrate 100 in the thickness direction of the substrate 100 or the third direction D3.

In an embodiment, a first thickness T1 of the second protrusion portion 181b, which is a distance from the upper surface of the first protrusion portion 172 to the upper surface of the second protrusion portion 181b, may be smaller than a second thickness T2 of the second flat portion 181a, which is a distance from the upper surface of the first flat portion 171 to the upper surface of the second flat portion 181a.

The light emitting layer 210 may be disposed on the pixel electrode 190. The light emitting layer 210 may include or be formed using at least one of light emitting materials that emit different color lights (e.g., red light, green light, blue light, and the like) according to the sub-pixels.

The common electrode 220 may be disposed on the pixel defining layer 180 and the light emitting layer 210. The common electrode 220 may include a metal, an alloy, a metal nitride, a conductive metal oxide, a transparent conductive material, or the like. These may be used alone or in combination with each other. In an embodiment, for example, the common electrode 220 may be a cathode electrode.

Accordingly, in such an embodiment, the light emitting element 300 including the pixel electrode 190, the light emitting layer 210, and the common electrode 220 may be disposed in the display area DA on the substrate 100.

The encapsulation structure 400 may be disposed on the common electrode 220. The encapsulation structure 400 may include at least one inorganic layer and at least one organic layer. In an embodiment, the encapsulation structure 400 may include the first inorganic encapsulation layer 230 disposed on the common electrode 220, the organic encapsulation layer 240 disposed on the first inorganic encapsulation layer 230, and the second inorganic encapsulation layer 250 disposed on the organic encapsulation layer 240.

The first inorganic encapsulation layer 230 may prevent the light emitting element 300 from being deteriorated due to penetration of moisture, oxygen, or the like. In addition, the first inorganic encapsulation layer 230 may also perform a function of protecting the light emitting element 300 from external impact. In an embodiment, for example, the first inorganic encapsulation layer 230 may include an inorganic insulating material having flexibility.

The organic encapsulation layer 240 may improve the flatness of the display device 10, and may protect the light emitting element 300 together with the first inorganic encapsulation layer 230. In an embodiment, for example, the organic encapsulation layer 240 may include an organic insulating material having flexibility.

The second inorganic encapsulation layer 250 together with the first inorganic encapsulation layer 230 may prevent the light emitting element 300 from being deteriorated due to penetration of moisture, oxygen, or the like. In addition, the second inorganic encapsulation layer 250 may protect the light emitting element 300 together with the first inorganic encapsulation layer 230 and the organic encapsulation layer 240 from external impact. In an embodiment, for example, the second inorganic encapsulation layer 250 may include an inorganic insulating material having flexibility.

A polarizing plate may not be disposed on the encapsulation structure 400. In such an embodiment, the display device 10 may not include the polarizing plate. Accordingly, the light efficiency of the display device 10 may be improved.

The light blocking layer 260 may be disposed on the encapsulation structure 400. The light blocking layer 260 may overlap the pixel defining layer 180. The light blocking layer 260 may be disposed to have a plurality of openings corresponding to the light emitting layer 210. The light blocking layer 260 may prevent visible rays of different colors implemented in the light emitting element 300 from abnormally mixing or affecting each other. In addition, the light blocking layer 260 may prevent members of the driving element 200 from being damaged by external light.

The light blocking layer 260 may include a light blocking material. In an embodiment, for example, the light blocking layer 260 may include a black organic material mixed with a black pigment, chromium oxide, and the like. In an embodiment, a color of the light blocking layer 260 is not limited to black, and alternatively, the light blocking layer 260 may include pigments or dyes of other colors.

The reflection control layer 270 may be disposed on the encapsulation structure 400. The reflection control layer 270 may cover the light blocking layer 260. The reflection control layer 270 may selectively pass only light of a specific wavelength, such as red light, green light, or blue light among the light emitted from the light emitting element 300, and may absorb light of the remaining wavelengths. In addition, the reflection control layer 270 may block light reflected by external light. In an embodiment, for example, the reflection control layer 270 may include an inorganic insulating material or an organic insulating material.

The overcoat layer 280 may be disposed on the reflection control layer 270. The overcoat layer 280 may prevent the reflection control layer 270 from being exposed from external moisture or air. In addition, the overcoat layer 280 may function as a planarization layer. In an embodiment, for example, the overcoat layer 280 may include an inorganic insulating material or an organic insulating material.

According to the invention, the planarization layer 170 includes the first flat portion 171 and the first protrusion portion 172 protruding in the direction thickness (e.g., the third direction D3) from the upper surface of the first flat portion 171 adjacent to the pixel electrode 190. The bank portion 181 disposed on the planarization layer 170 includes the second flat portion 181a and the second protrusion portion 181b protruding in the direction thickness from the upper surface of the second flat portion 181a overlapping the first protrusion 172. Accordingly, when a halftone mask is used in the photolithography process of forming the pixel defining layer 180 including the bank portion 181 and the spacer portion 182, the degree of crosslinking of the second protrusion portion 181b may be improved. In such an embodiment, the distribution of a critical dimension ("CD") of the pixel defining layer 180 may be improved.

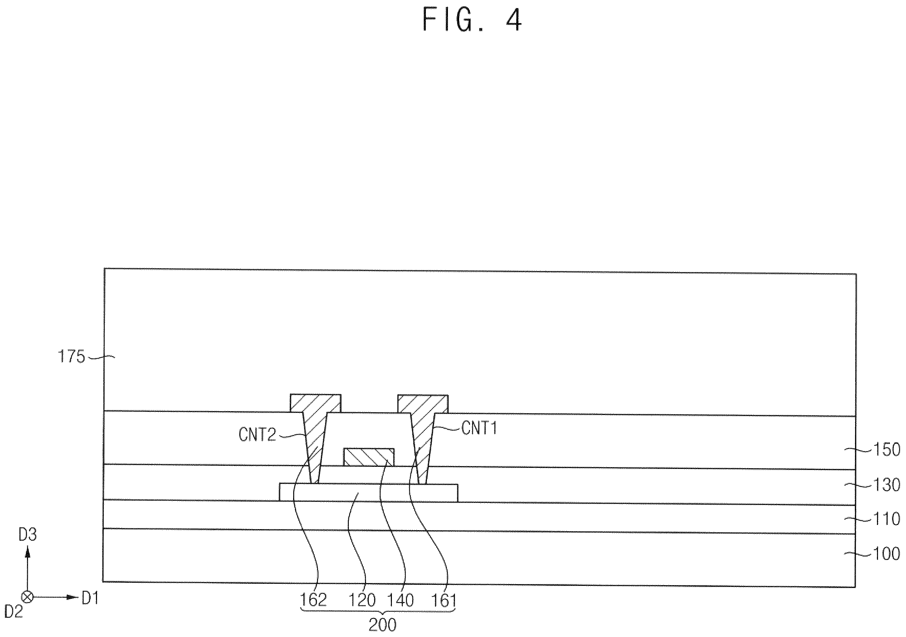

FIGS. 4, 5, 6, 7, 8, 9, and 10 are cross-sectional views illustrating an embodiment of a method of manufacturing the display device of FIG. 3.

Referring to FIG. 4, in an embodiment of a method of manufacturing the display device, the buffer layer 110 may be provided or formed on the substrate 100 including the display area DA and the peripheral area PA. The substrate 100 may include a transparent material or an opaque material. In an embodiment, for example, the substrate 100 may include a transparent resin substrate. In an embodiment, for example, the buffer layer 110 may be formed using silicon oxide, silicon nitride, or the like.

The active layer 120 may be formed in the display area DA on the buffer layer 110. The active layer 120 may include a metal oxide semiconductor, an inorganic semiconductor, or an organic semiconductor. The active layer 120 may include a source region, a drain region, and a channel region positioned between the source region and the drain region.

The gate insulating layer 130 may be provided or formed on the buffer layer 110. The gate insulating layer 130 may cover the active layer 120. In an embodiment, for example, the gate insulating layer 130 may be formed using silicon oxide, silicon nitride, silicon oxide, or the like.

The gate electrode 140 may be provided or formed in the display area DA on the gate insulating layer 130. The gate electrode 140 may overlap the channel region of the active layer 120. In an embodiment, for example, the gate electrode 140 may be formed using a metal, an alloy, a metal nitride, a conductive metal oxide, a transparent conductive material, or the like.

The interlayer insulating layer 150 may be provided or formed on the gate insulating layer 130. The interlayer insulating layer 150 may cover the gate electrode 140. In an embodiment, for example, the interlayer insulating layer 150 may be formed using silicon oxide, silicon nitride, silicon carbide, or the like.

In an embodiment, the first contact hole CNT1 exposing the source region of the active layer 120 may be defined through (e.g., formed by removing) a first portion of the gate insulating layer 130 and the interlayer insulating layer 150. In such an embodiment, the second contact hole CNT2 exposing the drain region of the active layer 120 may be defined through (e.g., formed by removing) a second portion of the gate insulating layer 130 and the interlayer insulating layer 150. Subsequently, a metal layer may be provided or formed on the interlayer insulating layer 150 while filing the first contact hole CNT1 and the second contact hole CNT2. By pattering the metal layer, the source electrode 161 and the drain electrode 162 may be formed respectively connected to the source region and the drain region. In an embodiment, for example, each of the source electrode 161 and the drain electrode 162 may be formed using a metal, an alloy, a metal nitride, a conductive metal oxide, a transparent conductive material, or the like.

A first photosensitive organic layer 175 may be provided or formed on the interlayer insulating layer 150. The first photosensitive organic layer 175 may cover the source electrode 161 and the drain electrode 162. In an embodiment, the first photosensitive organic layer 175 may be formed using an organic insulating material. In such an embodiment, since the first photosensitive organic layer 175 may be selectively removed by direct exposure without using a separate photoresist layer, a manufacturing process may be simplified. In an embodiment, for example, the first photosensitive organic layer 175 may be formed using a negative photosensitive material or a positive photosensitive material.

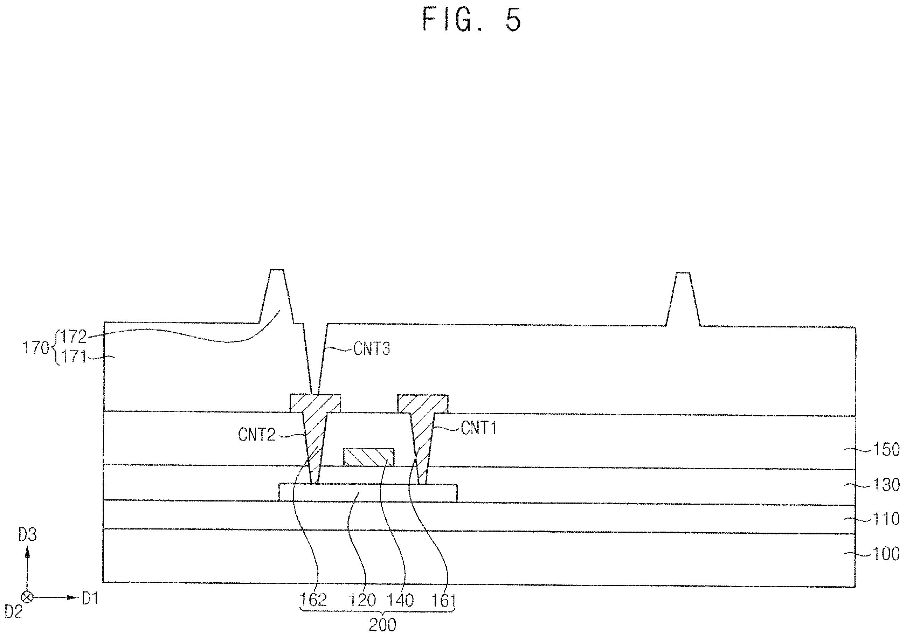

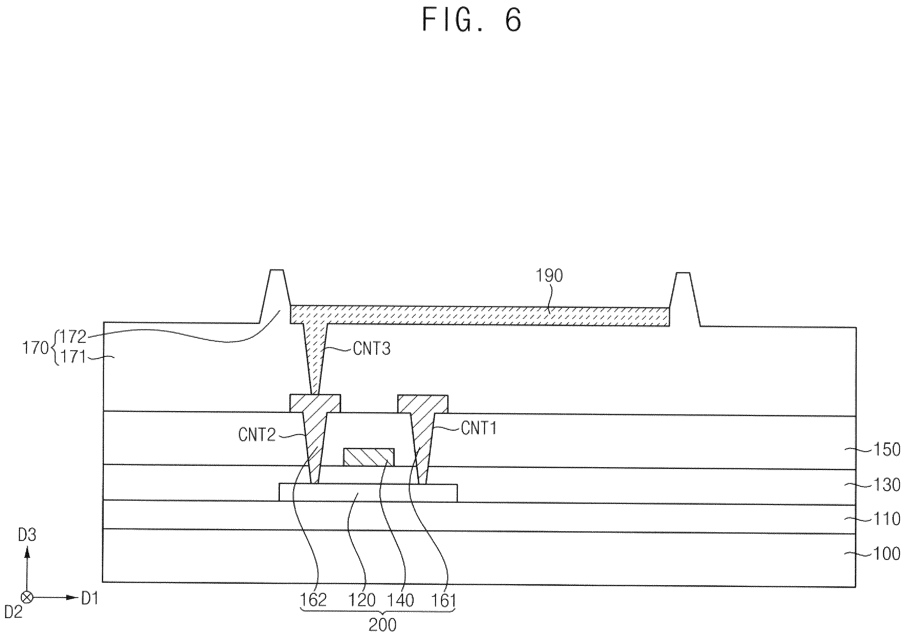

Referring to FIGS. 5 and 6, the planarization layer 170 including the first flat portion 171 and the first protrusion 172 protruding in the thickness direction from the upper surface of the first flat portion 171, and the third contact hole CNT3 exposing the drain electrode 162 may be formed through a photolithography process.

In an embodiment, a portion of the first photosensitive organic layer 175 may be removed by adjusting an exposure amount through a semi-transmission exposure process using a halftone mask or a slit mask. In such an embodiment, the first flat portion 171 and the first protrusion portion 172 of the planarization layer 170 may be formed, and the third contact hole CNT3 exposing the drain electrode 162 may be formed.

The pixel electrode 190 may be provided or formed on the planarization layer 170 while filling the third contact hole CNT3. The pixel electrode 190 may be connected to the drain electrode 162 through the third contact hole CNT3. In an embodiment, for example, the pixel electrode 190 may be formed using a metal, an alloy, a metal nitride, a conductive metal oxide, a transparent conductive material, or the like.

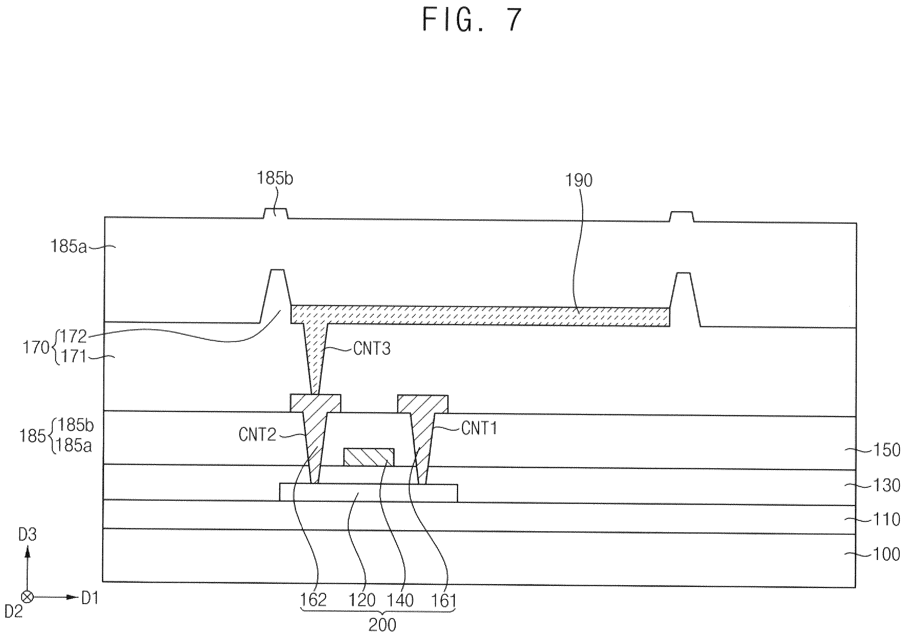

Referring to FIG. 7, a second photosensitive organic layer 185 may be provided or formed on the planarization layer 170 and the pixel electrode 190. The second photosensitive organic layer 185 may include a second flat portion 185a and a second protrusion portion 185b. The second protrusion portion 185b may protrude from an upper surface of the second flat portion 185a in the thickness direction and may overlap the first protrusion portion 172 of the planarization layer 170.

In an embodiment, the second photosensitive organic layer 185 may be formed using an organic insulating material. In an embodiment, the second photosensitive organic layer 185 may further include a black pigment or a black dye. In such an embodiment, since the second photosensitive organic layer 185 may be selectively removed by direct exposure without using a separate photosensitive layer, a manufacturing process may be simplified. The second photosensitive organic layer 185 may be formed using a negative photosensitive material.

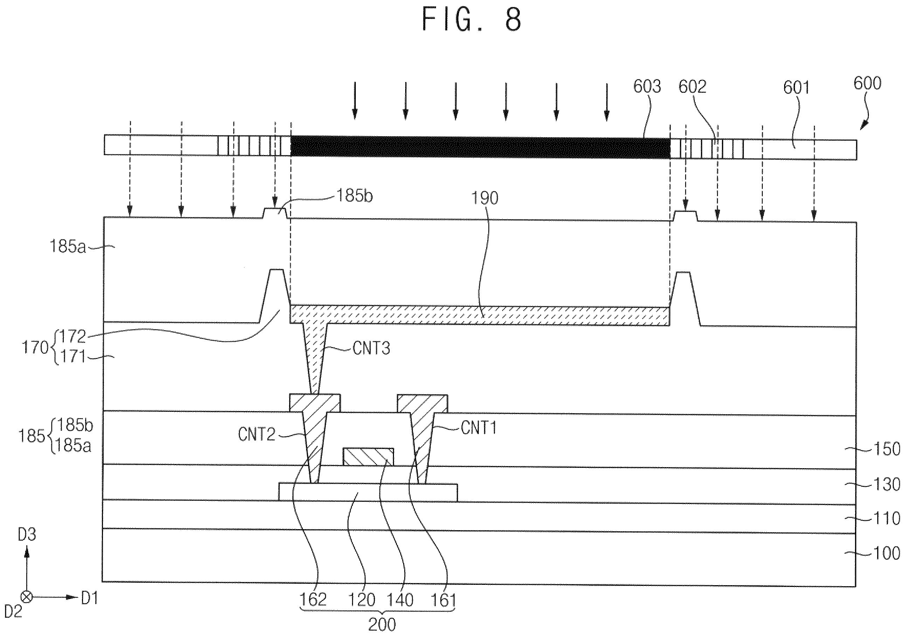

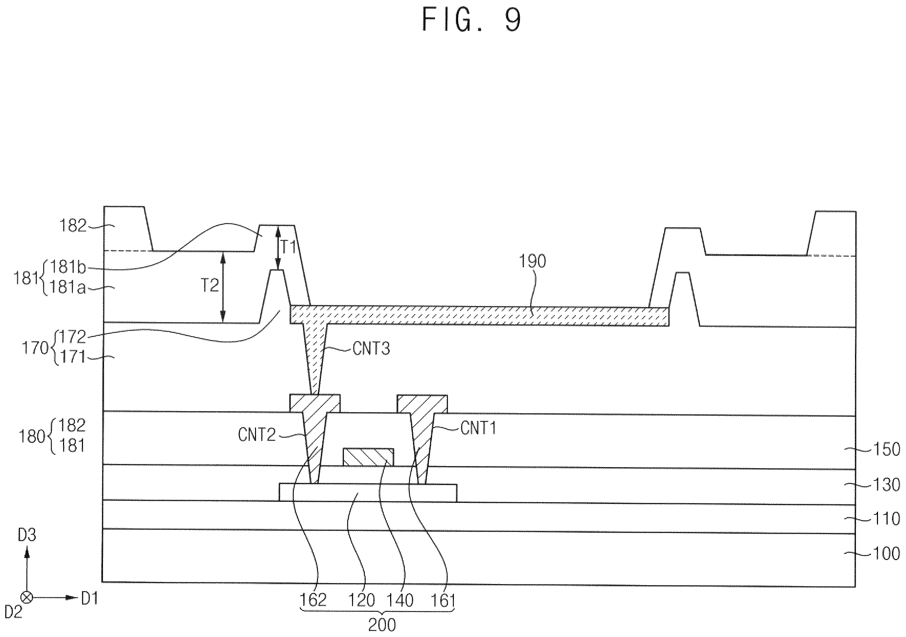

Referring FIGS. 8 and 9, the pixel defining layer 180 including the bank portion 181 including the second flat portion 181a and the second protrusion portion 181b protruding in the thickness direction from the upper surface of the second flat portion 181a, and the spacer portion 182 protruding in the thickness direction from the upper surface of the bank portion 181 may be formed through a photolithography process.

In an embodiment, a region in which the second photosensitive organic layer 185 is removed through the halftone mask 600 or the slit mask, a region in which the bank portion 181 is formed because the second photosensitive organic layer 185 remains, and a region in which the spacer portion 182 is formed because the second photosensitive organic layer 185 remains may be exposed to different degrees.

The halftone mask 600 may be divided into a first transmission portion 601 that transmits light entirely, a second transmission portion 602 that transmits light to an intermediate level, and a blocking portion 603 that substantially blocks light. The halftone mask 600 may be disposed such that the first transmission portion 601 corresponds to a region in which the spacer portion 182 is formed because the second photosensitive organic layer 185 remains, the second transmission portion 602 corresponds to a region in which the bank portion 181 is formed because the second photosensitive organic layer 185 remains, and the blocking portion 603 corresponds to a region in which the second photosensitive organic layer 185 is removed.

In an embodiment, the second transmission portion 602 may correspond to a region in which the second flat portion 181a of the bank portion 181 is formed because the second flat portion 185a of the second photosensitive organic layer 185 remains and a region in which the second protrusion portion 181b of the bank portion 181 is formed because the second protrusion portion 185b of the second photosensitive organic layer 185 remains, respectively.

The second photosensitive organic layer 185 may be removed through development in a portion where the light is blocked by the blocking portion 603, so that the upper surface of the pixel electrode 190 may be exposed. In addition, the second photosensitive organic layer 185 may remain in a portion through which all light are transmitted by the first transmission portion 601, so that the spacer portion 182 of the pixel defining layer 180 may be formed. The second photosensitive organic layer 185 may remain partially in a portion through which the light is transmitted through the second transmission portion 602 to an intermediate degree, so that the bank portion 181 of the pixel defining layer 180 may be formed.

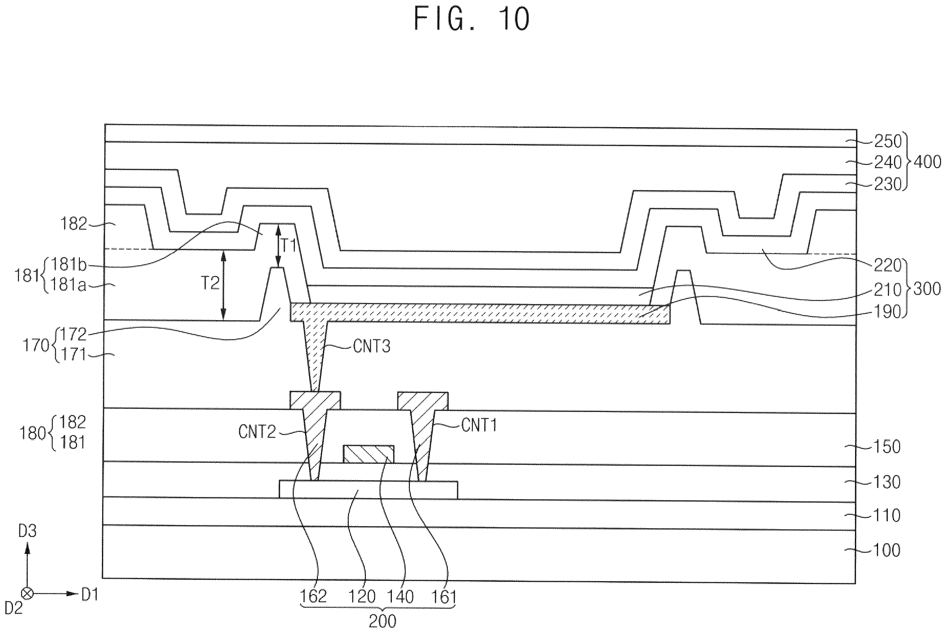

Referring to FIG. 10, the light emitting layer 210 may be provided or formed on the pixel electrode 190. The light emitting layer 210 may be formed using at least one of light emitting materials that emit different color lights from each other (e.g., red light, green light, blue light, and the like) according to the sub-pixels.

The common electrode 220 may be provided or formed on the pixel defining layer 180 and the light emitting layer 210. In an embodiment, for example, the common electrode 220 may be formed using a metal, an alloy, a metal nitride, a conductive metal oxide, a transparent conductive material, or the like.

The encapsulation structure 400 may be provided or formed on the common electrode 220. The encapsulation structure 400 may include the first inorganic encapsulation layer 230 formed on the common electrode 220, the organic encapsulation layer 240 formed on the first inorganic encapsulation layer 230, and the second inorganic encapsulation layer 250 formed on the organic encapsulation layer 240. In an embodiment, for example, each of the first inorganic encapsulation layer 230 and the second inorganic encapsulation layer 250 may be formed using an inorganic insulating material having flexibility. The organic encapsulation layer 240 may be formed using an organic insulating material having flexibility.

Referring back to FIGS. 2 and 3, a light blocking layer 260 may be provided or formed on the second inorganic encapsulation layer 250. The light blocking layer 260 may overlap the pixel defining layer 180. In an embodiment, a plurality of openings may be defined or formed through the light blocking layer 260 to correspond to the light emitting layer 210.

The reflection control layer 270 may be provided or formed on the second inorganic encapsulation layer 250. The reflection control layer 270 may cover the light blocking layer 260. In an embodiment, for example, the reflection control layer 270 may be formed using an inorganic insulating material or an organic insulating material. The overcoat layer 280 may be provided or formed on the reflection control layer 270. In an embodiment, for example, the overcoat layer 280 may be formed using an inorganic insulating material or an organic insulating material.

The window member 500 may be provided or disposed on the overcoat layer 280. The window member 500 may serve to protect the substrate 100, the driving element 200, the light emitting element 300, the encapsulation structure 400, and the like. In an embodiment, for example, the window member 500 may include or be formed using polyimide or the like.

Accordingly, an embodiment of the display device 10 illustrated in FIGS. 1, 2, and 3 may be manufactured through processes described above.

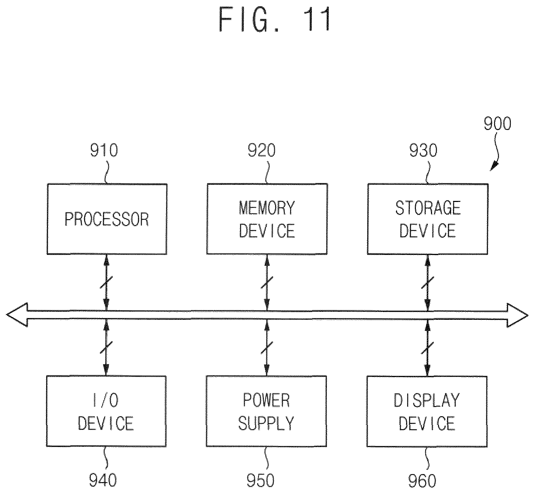

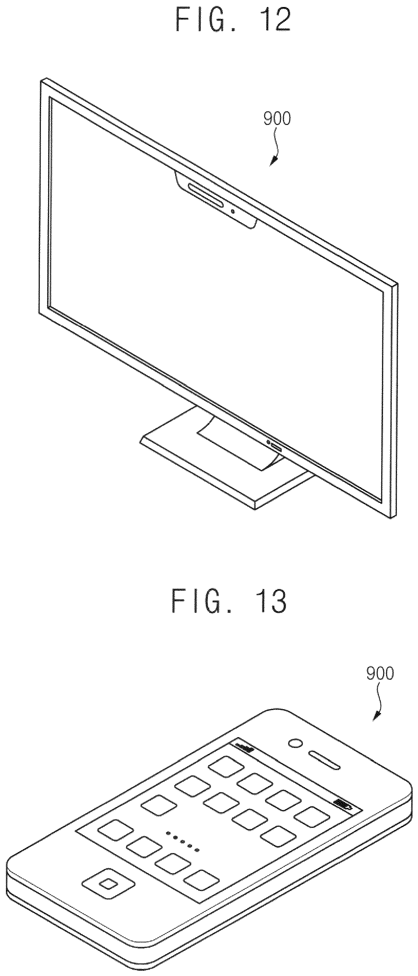

FIG. 11 is a block diagram illustrating an embodiment of an electronic device including the display device of FIG. 1. FIG. 12 is a diagram illustrating an embodiment in which the electronic device of FIG. 11 is implemented as a television. FIG. 13 is a diagram illustrating an embodiment in which the electronic device of FIG. 11 is implemented as a smartphone.

Referring to FIGS. 11, 12 and 13, in an embodiment, the electronic device 900 may include a processor 910, a memory device 920, a storage device 930, an input/output ("I/O") device 940, a power supply 950 and a display device 960. In such an embodiment, the display device 960 may correspond to the display device 10 described with reference to FIGS. 1, 2, and 3. The electronic device 900 may further include various ports capable of communicating with a video card, a sound card, a memory card, a USB device, or the like.

In an embodiment, as illustrated in FIG. 12, the electronic device 900 may be implemented as a television. In an alternative embodiment, as illustrated in FIG. 13, the electronic device 900 may be implemented as a smart phone. However, embodiments are not limited thereto, in another alternative embodiment, the electronic device 900 may be implemented as a cellular phone, a video phone, a smart pad, a smart watch, a tablet personal computer ("PC"), a car navigation system, a computer monitor, a laptop, a head disposed (e.g., mounted) display ("HMD"), or the like.

The processor 910 may perform various computing functions. In an embodiment, the processor 910 may be a microprocessor, a central processing unit ("CPU"), an application processor ("AP"), or the like. The processor 910 may be coupled to other components via an address bus, a control bus, a data bus, or the like. In an embodiment, the processor 910 may be coupled to an extended bus such as a peripheral component interconnection ("PCI") bus.

The memory device 920 may store data for operations of the electronic device 900. In an embodiment, the memory device 920 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like, and/or at least one volatile memory device such as a dynamic random access memory ("DRAM") device, a static random access memory ("SRAM") device, a mobile DRAM device, or the like.

The storage device 930 may include a solid state drive ("SSD") device, a hard disk drive ("HDD") device, a CD-ROM device, or the like. The I/O device 940 may include an input device such as a keyboard, a keypad, a mouse device, a touchpad, a touch-screen, or the like, and an output device such as a printer, a speaker, or the like.

The power supply 950 may provide power for operations of the electronic device 900. The display device 960 may be coupled to other components via the buses or other communication links. In an embodiment, the display device 960 may be included in the I/O device 940.

Embodiments of the disclosure may be applied to various electronic devices that may include a display device. In an embodiment, for example, embodiments of the disclosure may be applied to high-resolution smartphones, mobile phones, smart pads, smart watches, tablet PCs, in-vehicle navigation systems, televisions, computer monitors, notebook computers, and the like.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate (100) including a display area (DA) and a peripheral area (PA);
a driving element (200) disposed in the display area on the substrate;
a pixel electrode (190) disposed on the driving element and connected to the driving element;
a planarization layer (170) including a first flat portion (171) covering the driving element on the driving element and a first protrusion portion (172) protruding away from the substrate in a thickness direction (D3) from an upper surface of the first flat portion adjacent to the pixel electrode, wherein the pixel electrode is disposed on the first flat portion of the planarization layer to be adjacent to the first protrusion portion; and
a pixel defining layer (180) disposed on the planarization layer, wherein the pixel defining layer includes:
a bank portion (181), in which an opening is defined to expose a portion of the pixel electrode; and
a spacer portion (182) protruding away from the substrate in the thickness direction from an upper surface of the bank portion and spaced apart from the first protrusion portion when viewed from a plan view in the thickness direction;
**characterized in that** the bank portion includes:
a second flat portion (181a) disposed on the planarization layer; and
a second protrusion portion (181b) protruding away from the substrate in the thickness direction from an upper surface of the second flat portion overlapping the first protruding portion.

2. The display device of claim 1, wherein each of the bank portion and the spacer portion includes a black pigment.

3. The display device of claim 1 or claim 2, wherein each of the bank portion and the spacer portion includes a negative photosensitive material.

4. The display device of any preceding claim, wherein a first thickness (T1) of the second protrusion portion, which is a distance from an upper surface of the first protrusion portion to an upper surface of the second protrusion portion, is smaller than a second thickness (T2) of the second flat portion, which is a distance from the upper surface of the first flat portion to the upper surface of the second flat portion, in a cross-sectional view.

5. The display device of any preceding claim, wherein an upper surface of the spacer portion and an upper surface of the second protrusion portion are located at different levels from each other in a cross-sectional view, optionally wherein the upper surface of the spacer portion is located at a higher level than the upper surface of the second protrusion portion in the cross-sectional view.

6. The display device of any one of claims 1 to 5, wherein:
(i) the planarization layer includes an organic insulating material; and/or
(ii) the driving element includes:
an active layer (120) disposed on the substrate;
a gate electrode (140) disposed on the active layer; and
a source electrode (161) and a drain electrode (162), which are disposed on the gate electrode and connected to the active layer.

7. The display device of any one of claims 1 to 6, further comprising:
a light emitting layer (210) disposed on the pixel electrode; and
a common electrode (220) disposed on the pixel defining layer and the light emitting layer, optionally wherein the display device further comprises:
an encapsulation structure (400) disposed on the common electrode, wherein the encapsulation structure includes an organic layer (240) and an inorganic layer (230);
a light blocking layer (260) disposed on the encapsulation structure and overlapping the pixel defining layer; and
a reflection control layer (270) disposed on the encapsulation structure and covering the light blocking layer.

8. A display device according to claim 1, wherein the spacer includes a same material as the bank portion.

9. The display device of claim 8, wherein:
(i) each of the bank portion and the spacer portion includes a black pigment; and/or
(ii) each of the bank portion and the spacer portion includes a negative photosensitive material.

10. The display device of claim 8 or claim 9, wherein the bank portion includes:
a second flat portion (181a) disposed on the planarization layer; and
a second protrusion portion (181b) protruding in the thickness direction from an upper surface of the second flat portion overlapping the first protruding portion.

11. The display device of claim 10, wherein a first thickness (T1) of the second protrusion portion, which is a distance from an upper surface of the first protrusion portion to an upper surface of the second protrusion portion, is smaller than a second thickness (T2) of the second flat portion, which is a distance from the upper surface of the first flat portion to the upper surface of the second flat portion, in a cross-sectional view.

12. The display device of claim 10 or claim 11, wherein an upper surface of the spacer portion and an upper surface of the second protrusion portion are located at different levels from each other in a cross-sectional view, optionally wherein the upper surface of the spacer portion is located at a higher level than the upper surface of the second protrusion portion in the cross-sectional view.

13. The display device of any one of claims 8 to 12, wherein the planarization layer includes an organic insulating material.

14. The display device of any one of claims 8 to 13, further comprising:
a light emitting layer (210) disposed on the pixel electrode; and
a common electrode (220) disposed on the pixel defining layer and the light emitting layer, optionally wherein the display device further comprises:
an encapsulation structure (400) disposed on the common electrode, wherein the encapsulation structure includes an organic layer (240) and an inorganic layer (230);
a light blocking layer (260) disposed on the encapsulation structure and overlapping the pixel defining layer; and
a reflection control layer (270) disposed on the encapsulation structure and covering the light blocking layer.

## Patentansprüche

1. Anzeigevorrichtung, umfassend:
ein Substrat (100), das einen Anzeigebereich (DA) und einen peripheren Bereich (PA) beinhaltet;
ein Treiberelement (200), das im Anzeigebereich auf dem Substrat angeordnet ist;
eine Pixelelektrode (190), die auf dem Treiberelement angeordnet und mit dem Treiberelement verbunden ist;
eine Planarisierungsschicht (170), die einen ersten flachen Abschnitt (171), der das Treiberelement bedeckt, auf den Treiberelement und einen ersten Vorsprungsabschnitt (172), der in Dickenrichtung (D3) von einer Oberseite des ersten flachen Abschnitts, angrenzend an die Pixelelektrode, vom Substrat wegragt, beinhaltet, wobei die Pixelelektrode auf dem ersten flachen Abschnitt der Planarisierungsschicht so angeordnet ist, dass sie an den ersten Vorsprungsabschnitt angrenzt; und
eine Pixeldefinitionsschicht (180), die auf der Planarisierungsschicht angeordnet ist, wobei die Pixeldefinitionsschicht Folgendes beinhaltet:
einen Bankabschnitt (181), in dem eine Öffnung definiert ist, um einen Abschnitt der Pixelelektrode freizulegen; und
einen Abstandshalterabschnitt (182), der von einer Oberseite des Bankabschnitts in der Dickenrichtung vom Substrat wegragt und von dem ersten Vorsprungsabschnitt beabstandet ist, wenn man ihn aus einer Draufsicht in der Dickenrichtung betrachtet;
**dadurch gekennzeichnet, dass** der Bankabschnitt Folgendes beinhaltet:
einen zweiten flachen Abschnitt (181a), der auf der Planarisierungsschicht angeordnet ist; und
einen zweiten Vorsprungsabschnitt (181b), der von einer Oberseite des zweiten flachen Abschnitts in der Dickenrichtung vom Substrat wegragt und den ersten Vorsprungsabschnitt überlappt.

2. Anzeigevorrichtung nach Anspruch 1, wobei sowohl der Bankabschnitt als auch der Abstandsabschnitt jeweils ein schwarzes Pigment beinhalten.

3. Anzeigevorrichtung nach Anspruch 1 oder Anspruch 2, wobei sowohl der Bankabschnitt als auch der Abstandsabschnitt jeweils ein negativ lichtempfindliches Material beinhalten.

4. Anzeigevorrichtung nach einem vorstehenden Anspruch, wobei eine erste Dicke (T1) des zweiten Vorsprungsabschnitts, die ein Abstand von einer Oberseite des ersten Vorsprungsabschnitts zu einer Oberseite des zweiten Vorsprungsabschnitts ist, in einer Querschnittsansicht kleiner ist als eine zweite Dicke (T2) des zweiten flachen Abschnitts, die ein Abstand von der Oberseite des ersten flachen Abschnitts zur Oberseite des zweiten flachen Abschnitts ist.

5. Anzeigevorrichtung nach einem vorstehenden Anspruch, wobei sich eine Oberseite des Abstandshalterabschnitts und eine Oberseite des zweiten Vorsprungsabschnitts in einer Querschnittsansicht auf unterschiedlichen Ebenen zueinander befinden, wobei sich die Oberseite des Abstandshalterabschnitts in der Querschnittsansicht optional auf einer höheren Ebene befindet als die Oberseite des zweiten Vorsprungsabschnitts.

6. Anzeigevorrichtung nach einem der Ansprüche 1 bis 5, wobei:
(i) die Planarisierungsschicht ein organisches Isoliermaterial; beinhaltet; und/oder
(ii) das Treiberelement Folgendes beinhaltet:
eine aktive Schicht (120), die auf dem Substrat angeordnet ist;
eine Gate-Elektrode (140), die auf der aktiven Schicht angeordnet ist; und
eine Source-Elektrode (161) und eine Drain-Elektrode (162), die auf der Gate-Elektrode angeordnet und mit der aktiven Schicht verbunden sind.

7. Anzeigevorrichtung nach einem der Ansprüche 1 bis 6, ferner umfassend:
eine lichtemittierende Schicht (210), die auf der Pixelelektrode angeordnet ist; und
eine gemeinsame Elektrode (220), die auf der Pixeldefinitionsschicht und der lichtemittierenden Schicht angeordnet ist, wobei die Anzeigevorrichtung optional weiter Folgendes umfasst:
eine Verkapselungsstruktur (400), die auf der gemeinsamen Elektrode angeordnet ist, wobei die Verkapselungsstruktur eine organische Schicht (240) und eine anorganische Schicht (230) beinhaltet;
eine Lichtblockierungsschicht (260), die auf der Verkapselungsstruktur angeordnet ist und die Pixeldefinitionsschicht überlappt; und
eine Reflexionskontrollschicht (270), die auf der Verkapselungsstruktur angeordnet ist und die Lichtblockierungsschicht bedeckt.

8. Anzeigevorrichtung nach Anspruch 1, wobei der Abstandshalter ein gleiches Material wie der Bankabschnitt beinhaltet.

9. Anzeigevorrichtung nach Anspruch 8, wobei:
(i) sowohl der Bankabschnitt als auch der Abstandsabschnitt jeweils ein schwarzes Pigment beinhalten; und/oder
(ii) sowohl der Bankabschnitt als auch der Abstandsabschnitt jeweils ein negativ lichtempfindliches Material beinhalten.

10. Anzeigevorrichtung nach Anspruch 8 oder Anspruch 9, wobei der Bankabschnitt Folgendes beinhaltet:
einen zweiten flachen Abschnitt (181a), der auf der Planarisierungsschicht angeordnet ist; und
einen zweiten Vorsprungsabschnitt (181b), der von einer Oberseite des zweiten flachen Abschnitts in der Dickenrichtung wegragt und den ersten Vorsprungsabschnitt überlappt.

11. Anzeigevorrichtung nach Anspruch 10, wobei eine erste Dicke (T1) des zweiten Vorsprungsabschnitts, die ein Abstand von einer Oberseite des ersten Vorsprungsabschnitts zu einer Oberseite des zweiten Vorsprungsabschnitts ist, in einer Querschnittsansicht kleiner ist als eine zweite Dicke (T2) des zweiten flachen Abschnitts, die ein Abstand von der Oberseite des ersten flachen Abschnitts zur Oberseite des zweiten flachen Abschnitts ist.

12. Anzeigevorrichtung nach Anspruch 10 oder 11, wobei sich eine Oberseite des Abstandshalters und eine Oberseite des zweiten Vorsprungabschnitts in einer Querschnittsansicht auf unterschiedlichen Ebenen zueinander befinden, wobei sich die Oberseite des Abstandshalterabschnitts in der Querschnittsansicht optional auf einer höheren Ebene befindet als die Oberseite des zweiten Vorsprungabschnitts.

13. Anzeigevorrichtung nach einem der Ansprüche 8 bis 12, wobei die Planarisierungsschicht ein organisches Isoliermaterial beinhaltet:

14. Anzeigevorrichtung nach einem der Ansprüche 8 bis 13, ferner umfassend:
eine lichtemittierende Schicht (210), die auf der Pixelelektrode angeordnet ist; und
eine gemeinsame Elektrode (220), die auf der Pixeldefinitionsschicht und der lichtemittierenden Schicht angeordnet ist, wobei die Anzeigevorrichtung optional weiter Folgendes umfasst:
eine Verkapselungsstruktur (400), die auf der gemeinsamen Elektrode angeordnet ist, wobei die Verkapselungsstruktur eine organische Schicht (240) und eine anorganische Schicht (230) beinhaltet;
eine Lichtblockierungsschicht (260), die auf der Verkapselungsstruktur angeordnet ist und die Pixeldefinitionsschicht überlappt; und
eine Reflexionskontrollschicht (270), die auf der Verkapselungsstruktur angeordnet ist und die Lichtblockierungsschicht bedeckt.

## Revendications

1. Dispositif d'affichage comprenant :
un substrat (100) incluant une zone d'affichage (DA) et une zone périphérique (PA) ;
un élément d'excitation (200) disposé dans la zone d'affichage sur le substrat ;
une électrode de pixel (190) disposée sur l'élément d'excitation et connectée à l'élément d'excitation ;
une couche de planarisation (170) incluant une première partie plane (171) recouvrant l'élément d'excitation sur l'élément d'excitation et une première partie saillante (172) faisant saillie loin du substrat dans une direction d'épaisseur (D3) depuis une surface supérieure de la première partie plane adjacente à l'électrode de pixel, dans lequel l'électrode de pixel est disposée sur la première partie plane de la couche de planarisation de manière à être adjacente à la première partie saillante ; et
une couche de définition de pixels (180) disposée sur la couche de planarisation, dans lequel la couche de définition de pixels inclut :
une partie banc (181), dans laquelle une ouverture est définie pour exposer une partie de l'électrode de pixel ; et
une partie entretoise (182) faisant saillie loin du substrat dans la direction d'épaisseur depuis une surface supérieure de la partie banc et espacée de la première partie saillante lorsqu'elle est vue depuis une vue en plan dans la direction d'épaisseur ;
**caractérisé en ce que** la partie banc inclut :
une seconde partie plane (181a) disposée sur la couche de planarisation ; et
une seconde partie saillante (181b) faisant saillie loin du substrat dans la direction d'épaisseur depuis une surface supérieure de la seconde partie plane chevauchant la première partie saillante.

2. Dispositif d'affichage selon la revendication 1, dans lequel chacune de la partie banc et de la partie entretoise inclut un pigment noir.

3. Dispositif d'affichage selon la revendication 1 ou la revendication 2, dans lequel chacune de la partie banc et de la partie entretoise inclut un matériau photosensible négatif.

4. Dispositif d'affichage selon une quelconque revendication précédente, dans lequel une première épaisseur (T1) de la seconde partie saillante, qui est une distance depuis une surface supérieure de la première partie saillante jusqu'à une surface supérieure de la seconde partie saillante, est plus petite qu'une seconde épaisseur (T2) de la seconde partie plane, qui est une distance depuis la surface supérieure de la première partie plane jusqu'à la surface supérieure de la seconde partie plane, dans une vue en coupe.

5. Dispositif d'affichage selon une quelconque revendication précédente, dans lequel une surface supérieure de la partie entretoise et une surface supérieure de la seconde partie saillante sont situées à des niveaux différents l'une de l'autre dans une vue en coupe, optionnellement dans lequel la surface supérieure de la partie entretoise est située à un niveau plus élevé que la surface supérieure de la seconde partie saillante dans la vue en coupe.

6. Dispositif d'affichage selon l'une quelconque des revendications 1 à 5, dans lequel :
(i) la couche de planarisation inclut un matériau isolant organique ; et/ou
(ii) l'élément d'excitation inclut :
une couche active (120) disposée sur le substrat ;
une électrode de grille (140) disposée sur la couche active ; et
une électrode de source (161) et une électrode de drain (162), qui sont disposées sur l'électrode de grille et connectées à la couche active.

7. Dispositif d'affichage selon l'une quelconque des revendications 1 à 6, comprenant en outre :
une couche d'émission de lumière (210) disposée sur l'électrode de pixel ; et
une électrode commune (220) disposée sur la couche de définition de pixels et la couche d'émission de lumière, optionnellement dans lequel le dispositif d'affichage comprend en outre :
une structure d'encapsulation (400) disposée sur l'électrode commune, dans lequel la structure d'encapsulation inclut une couche organique (240) et une couche inorganique (230) ;
une couche de blocage de lumière (260) disposée sur la structure d'encapsulation et chevauchant la couche de définition de pixels ; et
une couche de commande de réflexion (270) disposée sur la structure d'encapsulation et recouvrant la couche de blocage de lumière.

8. Dispositif d'affichage selon la revendication 1, dans lequel l'entretoise inclut le même matériau que la partie banc.

9. Dispositif d'affichage selon la revendication 8, dans lequel :
(i) chacune de la partie banc et de la partie entretoise inclut un pigment noir ; et/ou
(ii) chacune de la partie banc et de la partie entretoise inclut un matériau photosensible négatif.

10. Dispositif d'affichage selon la revendication 8 ou la revendication 9, dans lequel la partie banc inclut :
une seconde partie plane (181a) disposée sur la couche de planarisation ; et
une seconde partie saillante (181b) faisant saillie dans la direction d'épaisseur depuis une surface supérieure de la seconde partie plane chevauchant la première partie saillante.

11. Dispositif d'affichage selon la revendication 10, dans lequel une première épaisseur (T1) de la seconde partie saillante, qui est une distance depuis une surface supérieure de la première partie saillante jusqu'à une surface supérieure de la seconde partie saillante, est plus petite qu'une seconde épaisseur (T2) de la seconde partie plane, qui est une distance depuis la surface supérieure de la première partie plane jusqu'à la surface supérieure de la seconde partie plane, dans une vue en coupe.

12. Dispositif d'affichage selon la revendication 10 ou la revendication 11, dans lequel une surface supérieure de la partie entretoise et une surface supérieure de la seconde partie saillante sont situées à des niveaux différents l'une de l'autre dans une vue en coupe, optionnellement dans lequel la surface supérieure de la partie entretoise est située à un niveau plus élevé que la surface supérieure de la seconde partie saillante dans la vue en coupe.

13. Dispositif d'affichage selon l'une quelconque des revendications 8 à 12, dans lequel la couche de planarisation inclut un matériau isolant organique.

14. Dispositif d'affichage selon l'une quelconque des revendications 8 à 13, comprenant en outre :
une couche d'émission de lumière (210) disposée sur l'électrode de pixel ; et
une électrode commune (220) disposée sur la couche de définition de pixels et la couche d'émission de lumière, optionnellement dans lequel le dispositif d'affichage comprend en outre :
une structure d'encapsulation (400) disposée sur l'électrode commune, dans lequel la structure d'encapsulation inclut une couche organique (240) et une couche inorganique (230) ;
une couche de blocage de lumière (260) disposée sur la structure d'encapsulation et chevauchant la couche de définition de pixels ; et
une couche de commande de réflexion (270) disposée sur la structure d'encapsulation et recouvrant la couche de blocage de lumière.
